# EUROPÄISCHE PATENTSCHRIFT

(11) **EP 0 679 897 B1**
(45) Veröffentlichungstag und Bekanntmachung des Hinweises auf die Patenterteilung: **05.01.2000**
(21) Anmeldenummer: 95106100.1
(22) Anmeldetag: 24.04.1995
(51) Int. Cl.: G01P 15/08, G01P 15/125, G01L 1/14, H02N 1/00

(54) **Mikromechanisches Bauteil mit einer dielektrischen beweglichen Struktur**
Micromechanical component having a moving dielectric element
Composant microméchanique avec une structure mobile diélectrique

(30) Priorität: 28.04.1994 DE 4414969
(43) Veröffentlichungstag der Anmeldung: 02.11.1995
(60) Teilanmeldung: 99112288.8
(73) Patentinhaber: SIEMENS AKTIENGESELLSCHAFT, 80333 München (DE)
(72) Erfinder: Zettler, Thomas, Dr., D-81737 München (DE)

(56) Entgegenhaltungen:
- WO-A-90/09059
- DE-A- 2 816 600
- SENSORS AND ACTUATORS A, Bd. 39, Nr. 3, Dezember 1993 LAUSANNE, CH, Seiten 209-217, Y. MATSUMOTO ET AL 'Integrated silicon capacative accelerometer with PLL servo technique.'

## Beschreibung

Die Erfindung betrifft ein mikromechanisches Bauteil mit einer festen mikromechanischen Struktur, die ein Kondensatorplattenpaar umfaßt, und einer beweglichen mikromechanischen Struktur, ein Mikrosystem auf einem Halbleitersubstrat mit einer integrierten Schaltung und dem mikromechanischen Bauteil sowie ein Herstellverfahren.

Mikromechanische Bauteile werden zu verschiedenen Zwecken eingesetzt, ein wichtiges Anwendungsgebiet sind proportionale und nicht-proportionale Kraftsensoren (Beschleunigungs- und Neigungssensoren). Die bekannten derartigen Sensoren besitzen feste und bewegliche mikromechanische Strukturen und basieren auf der kapazitiven Messung der Variation des Elektrodenabstandes eines mikromechanischen Kondensators. Bspw. Wird in dem Artikel von Sherman et al., Conf. Proc. IEDM 1992, S. 501 (Nr. 0-7803-0817-4/92 IEEE) eine Struktur vorgeschlagen, bei der sich eine bewegliche aufgehängte Polysiliziumzunge zwischen zwei fest angebrachten Zungen befindet. Eine Beschleunigung verändert den Abstand der beweglichen Zunge relativ zu den festen Zungen, wodurch die Kapazität zu einer der festen Zungen zunimmt und zur anderen abnimmt. Diese Änderung wird elektrisch detektiert.

In dem Artikel von Y. Matsumoto et al., Sensors and Actuators A, Bd. 39, Nr. 3, Dez. 1993, Lausanne, S.209-217 ist ein Beschleunigungssensor in Form eines Kondensators beschrieben, wobei eine Kondensatorplatte metallisch und fest und die andere Kondensatorplatte aus Silizium und federnd beweglich ist. Die Kapazitätsänderung aufgrund der Änderung des Plattenabstands wird mit einer Referenzkapazität verglichen.

Aus der DE 28 16 600 ist ein makroskopischer Sensor zur Wegerfassung und zum Positionieren von Werkstücken bekannt, bei dem ein profiliertes Dielektrikum durch mechanische Betätigung zwischen einem Kondensatorplattenpaar bewegt wird.

Bei der Herstellung von derartigen mikromechanischen Bauteilen besteht ein großes Interesse an Prozessen, die mit der Fertigung von integrierten Schaltungen, insbesondere auf einem Silizium-Substrat, kompatibel sind. Nur eine Kompatibilität der Herstellungsprozesse erlaubt die Integration von Mikromechanik und Ansteuer- oder Auswerteschaltungen in Mikrosystemen. Dies ist auch dann wichtig, wenn bestehende Halbleiterfertigungsanlagen auch zur Herstellung von mikromechanischen Strukturen genutzt werden sollen. Besonders vorteilhaft wäre ein Prozeß, mit dem gleichzeitig eine integrierte Schaltung und ein mikromechanisches Bauteil in verschiedenen Bereichen des Halbleitersubstrats erzeugt werden, d.h. ein Mikrosystem mit nur minimalem zusätzlichem Prozeßaufwand zur integrierten Schaltung hergestellt wird.

Für mikromechanische Bauteile sind u.a. folgende Herstellprozesse bekannt:
a) Polysilizium Center-pin- und Flange-Prozeß (M. Mehrengany, Y.-C. Tai, J. Micromech. Microeng., vol. 1, 73, 1991)
   Dieser Prozeß erfordert bei der Herstellung der mikromechanischen Strukturen im Anschluß an die Herstellung der integrierten Schaltung zusätzliche Polysiliziumabscheidungen nach dem Metallisierungskomplex. Im Fall, daß der Center-Pin-Prozeß vor der Metallisierung der integrierten Schaltung durchgeführt werden soll, ergibt sich das Problem, die beweglichen Strukturen freizuätzen, und gleichzeitig die Isolation der Metallisierung zu schützen. Ein weiterer Nachteil ist der relativ hohe spezifische Widerstand von dotiertem Polysilizium.
b) Polysilizium LOCOS-Prozeß (L.S. Tavrow et al, Sensors and Actuators A, Phys. vol. A35, 33, 1992):
   Der Prozeß sieht vor, die beweglichen mikromechanischen Strukturen auf einer planen LOCOS-0xidschicht herzustellen, wobei der Oxidationsschritt wegen der Temperaturbelastung nur vor der Transistorherstellung einer integrierten Schaltung erfolgen. Bei vollständiger Durchführung des Prozesses vor Herstellung der integrierten Schaltung ergibt sich eine ungünstige Topologie für die Nachfolgeschritte sowie das Problem, die mikromechanischen Strukturen während der Herstellung der integrierten Schaltung zu schützen. Bei einer ineinander verzahnten Herstellung muß das Problem der Freiätzung des Rotors bei gleichzeitigem Schutz der Schaltungsisolationsoxide gelöst werden.
c) Selektiver Wolfram-Prozeß (L.Y.Chen et al, TRANSDUCERS '91., Int. Conf. on Solid-State Sensors and Actuators. San Francisco, USA, IEEE Cat. No. 91CH2817-5, 739, 1991): Dieser Prozeß kann im Anschluß an einen Schaltungs-Fertigungsprozeß durchgeführt werden, wobei das Problem der elektrischen Kontaktierung und des Schutzes der Metallisierungsisolation durch das vorgeschlagene Verfahren nicht gelöst werden. Der Prozeß ist insbesondere bezüglich der Lithographieschritte sehr aufwendig.
d) LIGA-Prozeß (P.Bley et al, Microelectronic Engineering 13, 509, 1991; H. Guckel et al, Conf. Proceedings IEEE-Micro Electro Mechanical Systems, Nara, Japan, 1991): Dieser Prozeß benötigt Röntgenstrahl-Lithographie und eventuell eine nachträgliche Montage von losen mikroskopischen Bauteilen.

Alle diese Prozesse sind in ihrer Konzeption nicht für die gemeinsame und insbesondere gleichzeitige Fertigung von integrierter Schaltung und dem mikromechanischen Bauteil in einem Mikrosystem ausgelegt. Sie benötigen eine Vielzahl von Schichten und Prozeßschritten, welche ausschließlich der Herstellung des mikromechanischen Bauteils dienen und die für die Herstellung einer integrierten Schaltung überflüssig oder sogar einschränkend oder nachteilig sind.

Der Erfindung liegt daher die Aufgabe zugrunde, ein neuartiges Konzept und ein Herstellverfahren für ein mikromechanisches Bauteil anzugeben, das als proportionaler oder nicht-proportionaler Kraftsensor eingesetzt werden kann, sowie ein Mikrosystem mit einer integrierten Schaltung und einem mikromechanischen Bauteil und ein Herstellverfahren anzugeben, bei welchem ausgehend von der IS-Herstellung ein nur minimaler zusätzlicher Prozeßaufwand für die Herstellung des mikromechanischen Bauteils notwendig ist.

Diese Aufgabe wird durch die Merkmale der Ansprüche 1, 7, 9 und 15 gelöst.

Die Erfindung beruht auf der Verwendung einer dielektrischen beweglichen Struktur, die durch die zu messende Kraft zwischen ein Kondensatorplattenpaar als fester mikromechanischer Struktur eingeführt wird, so daß dessen Kapazität sich ändert. Die Kapazitätsänderung wird gemessen. Umgekehrt kann die Kraft auch die Entfernung des Dielektrikums aus dem Zwischenraum bewirken. Die dielektrische Struktur kann frei oder federnd beweglich sein, so daß das Bauteil einen nicht-proportionalen oder einen proportionalen Kraftsensor darstellt. Das Bauteilprinzip kann ebenso für Aktoren verwendet werden, da das Feld eines geladenen Kondensators auf das Dielektrikum eine Kraft ausübt. In jedem Fall ist ein Material mit hoher Dielektrizitätskonstante sr vorteilhaft, also z.B. Siliziumnitrid.

Bei dem erfindungsgemäßen Herstellverfahren wird das Kondensatorplattenpaar aus derselben oder aus verschiedenen leitenden Schichten und die bewegliche Struktur aus einer dielektrischen Schicht strukturiert. Feste und bewegliche Strukturen sind dabei durch eine isolierende Schicht von einander getrennt. Dann wird eine Maske aufgebracht und ein Ätzprozeß mit einer isotropen Komponente durchgeführt, der die isolierende Schicht mindestens um das Dielektrikum herum selektiv zur festen Struktur entfernt. Nach dem Ätzprozeß ist das Dielektrikum frei oder federnd beweglich. Bei einer frei beweglichen mikromechanischen Struktur besitzt diese nach dem Ätzprozeß keine Verbindung mehr zum übrigen Bauteil. Bei einer federnd beweglichen mikromechanischen Struktur ist noch eine Verbindung vorhanden, und zwar vorzugsweise über einen seitlich herausgeführten Teil der dielektrischen Schicht mit geringer Querschnittsfläche, der auf seiner anderen Seite z.B. mit einer Befestigungsplatte verbunden ist und als Federelement zwischen beweglicher Struktur und Befestigungsplatte wirkt.

Mit dem Verfahren kann ein proportionaler oder nicht-proportionaler Kraftsensor oder ein Motor mit dielektrischem Rotor hergestellt werden. Im ersten Fall werden vorzugsweise übereinanderliegende leitende Schichten für das Kondensatorplattenpaar verwendet, so daß es im wesentlichen parallel zur Substratoberfläche angeordnet ist. Zwischen den leitenden Schichten befindet sich eine untere isolierende Schicht, die dielektrische Schicht und eine obere isolierende Schicht. Alternativ, beispielsweise zur Bildung eines nicht-proportionalen Sensors, können ein oder mehrere Kondensatorplattenpaare vorzugsweise aus derselben leitenden Schicht strukturiert, die isolierende und die dielektrische Schicht aufgebracht und die dielektrische Schicht zu einer im Plattenzwischenraum (nach dem Ätzprozeß) frei beweglichen Struktur strukturiert; die dielektrische Struktur kann auch vor den Kondensatorplatten hergestellt werden. Ein nicht-proportionaler Sensor kann je nach Anforderung mit beiden Konzepten realisiert werden.

Die Erfindung umfaßt auch ein Mikrosystem mit einer Integrierten Schaltung (IS) und dem erläuterten mikromechanischen Bauteil (BT). Bei dem erfindungsgemäßen Mikrosystem werden eine oder mehrere leitende Schichten, die bereits für die Verdrahtung der integrierten Schaltung benötigt werden, als Teile des mikromechanischen Bauteils verwendet. Diese Schicht oder Schichten müssen lediglich durch ein entsprechendes Design so strukturiert werden, daß im Bereich des mikromechanischen Bauteils ein Kondensatorplattenpaar als feste mikromechanische Struktur gebildet wird. Die Herstellung der dielektrischen Struktur erfolgt i.a. in einem zur IS-Herstellung zusätzlichen Prozeßschritt, der isotrope Ätzprozeßwird bei der IS-Herstellung bereits zur Freiätzung der Anschlußpads benötigt. Die integrierte Schaltung kann eine Ein- oder Mehrlagenverdrahtung (d.h. eine oder mehrere Metallisierungsebenen) aufweisen, von denen eine, mehrere oder alle für das mikromechanische Bauteil verwendet werden können. Ferner kann die integrierte Schaltung in einer beliebigen Technologie, bspw. CMOS, ausgeführt werden.

Die Erfindung wird im folgenden anhand von Ausführungs beispielen, die in den Figuren dargestellt sind, näher er läutert. Es zeigen:
- FIG 1 - 2: einen Querschnitt durch ein Halbleitersubstrat im Bereich des mikromechanischen Bauteils, an dem das Verfahren verdeutlicht wird,
- FIG 3: eine Aufsicht auf das mikromechanische Bauteil aus FIG 1
- FIG 4 - 6: einen Querschnitt durch bzw. eine Aufsicht auf ein mikromechanisches Bauteil gemäß einer weiteren Ausführungsform der Erfindung.

### FIG 1 - 3:

Als erstes Ausführungsbeispiel wird ein mikromechanisches Bauteil beschrieben, das als nicht-proportionaler Kraftsensor eingesetzt werden kann. Es besitzt ein im wesentlichen parallel zur Substratoberfläche (horizontal) angeordnetes Kondensatorplattenpaar, gebildet aus den leitenden Schichten 2 und 7, als festes mikromechanisches Bauteil sowie ein im wesentlichen horizontal bewegliches Dielektrikum 4 als frei bewegliches mikromechanisches Bauteil. Vorzugsweise ist das Dielektrikum ringförmig ausgebildet und mit einer Sicherung gegen Herausfallen versehen, die aus der oberen leitenden Schicht gebildet werden kann.

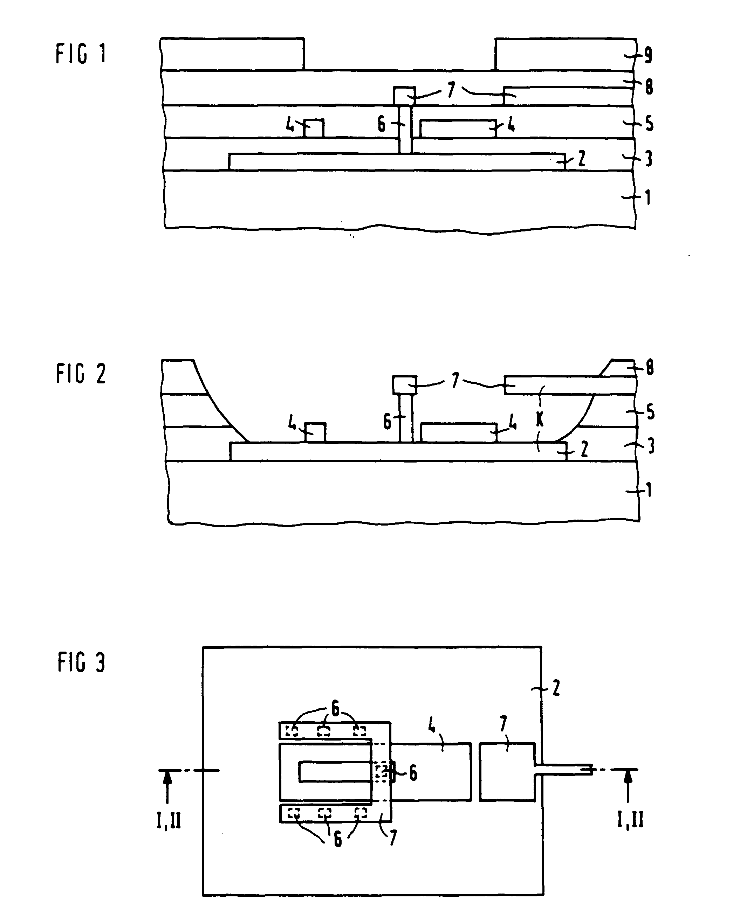

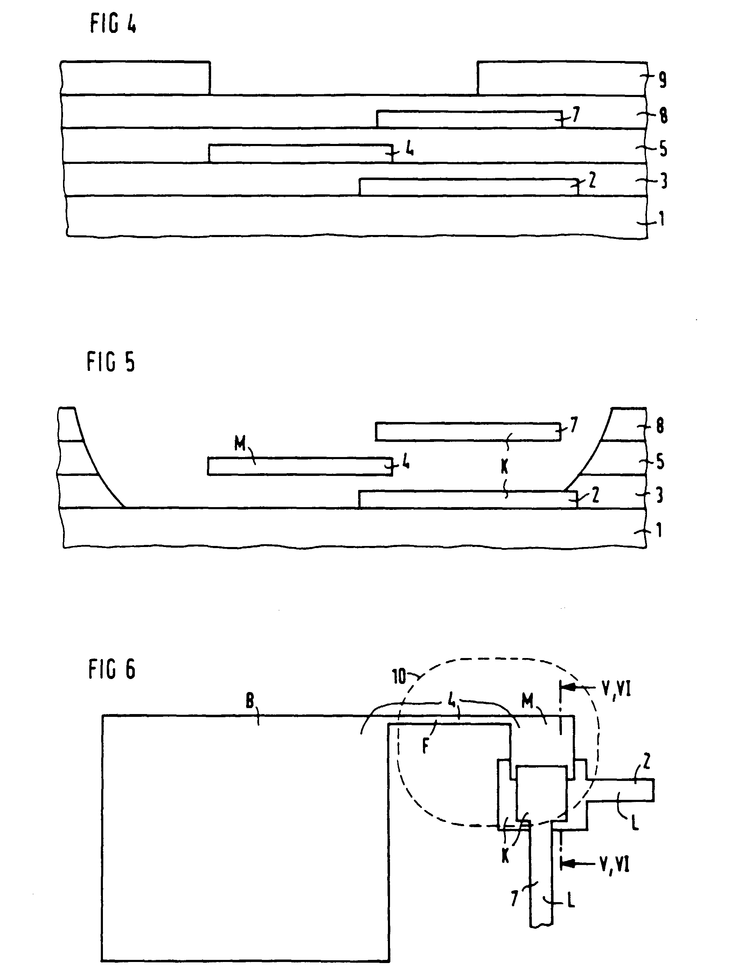

In FIG 1 ist ein Substrat 1 mit beliebiger Oberfläche (z.B. Silizium oder ein Feldoxid ) dargestellt.Auf dem Substrat wird eine untere leitende Schicht 2, bspw. eine Polysiliziumschicht oder eine erste Metallisierungsebene, aufgebracht und strukturiert. Die untere leitende Schicht 2 wird mit einer unteren isolierenden Schicht 3 abgedeckt, auf dieser wird eine dielektrische Schicht 4 aufgebracht und zur beweglichen Struktur strukturiert. Es wird eine obere isolierende Schicht 5 aufgebracht und ggf. mit Kontaktlöchern versehen, die dann mit einem geeigneten Material zu Kontakten 6 aufgefüllt werden. Im BT-Bereich dienen diese Kontakte zur Herstellung der (mechanischen) Sicherung, so daß ihr elektrischer Widerstand hier unwesentlich ist. Auf der oberen isolierenden Schicht 5 wird die obere leitende Schicht 7 aufgebracht und derart strukturiert, daß sie in einem vorgegebenen Bereich ein Kondensatorplattenpaar mit der unteren leitenden Schicht 2 bildet, also diese teilweise überlappt. Das Dielektrikum 4 ist derart strukturiert, daß es (nach dem isotropen Ätzprozeß) in den Zwischenraum zwischen den Kondensatorplatten einführbar bzw. aus ihm entfernbar ist. Aus der Schicht 7 kann außerdem eine Sicherung gegen das Herausfallen der später freizulegenden beweglichen Strukturen gebildet werden, beispielsweise indem ein geschlossener Bügel mit Hilfe der unterliegenden Schichten (s.FIG 3) gebildet wird, oder indem auf dem Kontakt 6 eine Fläche gebildet wird, die einen größeren Durchmesser als den entsprechenden Innendurchmesser des ringförmigen Dielektrikums 4 besitzt. Die obere leitende Schicht wird mit einer weiteren Isolation 8 (Passivierung) abgedeckt.

Es wird eine Maske 9 aufgebracht, die im BT-Bereich eine Öffnung oberhalb der freizulegenden beweglichen Struktur 4 aufweist, dann werden die isolierenden Schichten 3, 5, 8 geätzt. Dabei müssen folgende Bedingungen berücksichtigt werden:
- Der Ätzprozeß muß ausreichend selektiv zum Dielektrikum 4, den leitenden Schichten 2, 7 und in diesem Beispiel auch zum Kontakt 6 sein,
- die isotrope Komponente des Ätzprozesses und die Größe der Öffnung in der Maske müssen unter Berücksichtigung der einzelnen Schichtdicken so gewählt sein, daß das Dielektrikum 4 völlig unterätzt wird. Der Plattenzwischenraum muß ebenfalls weit genug freigeätzt sein.
Der Ätzprozeß wird vorzugsweise als Naßätzung mit einer gepufferten HF-Lösung oder als mikrowellenunterstützte Trockenätzung durchgeführt.

Für die einzelnen Schritte des Herstellungsverfahrens können die aus der IS-Fertigung bekannten Prozesse und Materialien (bspw. Siliziumoxid als isolierende und Al-Legierungen als leitende Schicht) eingesetzt werden. Beispielsweise kann die Herstellung der Metallebene auch gleichzeitig mit der Auffüllung der Kontakte erfolgen, indem nach Ätzen der Kontaktlöcher in die entsprechende Isolationsschicht eine Haftschicht (beispielsweise 40nm Ti + 100nm TiN) abgeschieden und dann in einem CVD-Prozeß Wolfram zur Kontaktlochauffüllung und gleichzeitig als Metallisierungsebenen aufgebracht wird.

Das Bauteil kann in ein Mikrosystem integriert werden, wobei die Herstellung der IS (z.B. Ansteuer- oder Auswerteschaltung in CMOS-Technologie) gleichzeitig mit dem beschriebenen Prozeß erfolgt. Dabei werden vorzugsweise folgende Punkte berücksichtigt:
- An dem Substrat 1 werden weitere, für die Herstellung der integrierten Schaltung notwendigen Verfahrensschritte vorgenommen, also beispielsweise Herstellen von epitaktischen Schichten, dotierten Wannen, Kanalimplantation, Gate-0xid. Für die Gate-Ebene der IS kann die untere leitende Schicht 2 verwendet werden, für die Gate-Isolation (Zwischenoxid) bspw die Schicht 3. Es wird u.a. eine Implantation der Source/Drain-Gebiete durchgeführt.
- Mithilfe der Kontakte 6 wird im IS-Bereich ein elektrischer Kontakt 6 der Metallisierungsebene 7 zur Gateebene 2 hergestellt.
- Im IS-Bereich dienen Kontakte 6 und die erste Metallisierungsebene beispielsweise auch zum Anschluß von S/D-Gebieten von Transistoren.
- Als isolierende Schichten werden vorzugsweise - in situ oder durch geeignete Prozesse - planare Schichten eingesetzt. Planare Schichten sind auch im BT-Bereich vorteilhaft.
- Die weitere Isolation 8 besteht aus einer Passivierung aus Siliziumoxid und -nitrid.Die aufgebrachte Maske (9), die im BT-Bereich eine Öffnung oberhalb der freizulegenden beweglichen Struktur aufweist, besitzt im IS-Bereich oberhalb der von außen anzuschließenden Pads Öffnungen. Im IS-Bereich muß die isotrope Ätzung auf diesen Anschluß-Pads stoppen.

Ein Ausschnitt aus einer solchen beispielhaften CMOS-Schaltung ist in der deutschen Patentanmeldung "Mikrosystem mit integrierter Schaltung und mikromechanischem Bauteil und Herstellverfahren" desselben Erfinders und desselben Anmelders in den Figuren 1 und 2(mit einer 2-Lagen-Metallisierung) dargestellt, auf die diesbezüglich verwiesen wird.

Das Mikrosystem kann als nicht-proportionaler Kraftsensor (Ereignissensor) universell eingesetzt werden. So kann die kapazitiv detektierte Lageveränderung des Ringes auch z.B. durch die Kraft von strömenden Medien oder direkte mechanische Einwirkung hervorgerufen werden.

### FIG 4 bis 6:

Als zweites Beispiel wird ein mikromechanisches Bauteil beschrieben, das als proportionaler Kraftsensor eingesetzt werden kann. Es umfaßt
- ein Kondensatorplattenpaar K, das aus einer oberen und einer unteren leitenden Schicht gebildet ist,
- ein Masse-Element M, das aus einer dielektrischen Schicht 4 gebildet, federnd aufgehängt und verschieden tief in den Plattenzwischenraum einführbar ist,
- ein Feder-Element F, welches auf einer Seite mit dem Masse-Element und auf der anderen Seite mit einer Befestigungsplatte verbunden ist, und
- eine Befestigungsplatte B, die mit dem Substrat und dem Feder-Element verbunden ist.

Vorzugsweise werden Masse, Feder und Befestigungsplatte aus derselben Schicht gebildet. Es kann jedoch bei bestimmten Aufgabenstellungen auch vorteilhaft sein, beispielsweise Feder-Element und Befestigungsplatte aus leitenden Schichten herzustellen. Die Befestigungsplatte und die Kondensatorplatten stellen feste mikromechanische Strukturen dar, das Masse-Element und das Feder-Element (zumindest über einen ausreichenden Teil) bewegliche mikromechanische Strukturen. Die Befestigungsplatte übernimmt die Aufgabe einer mechanischen Verbindung des Feder-Elementes mit dem Substrat. Die Befestigungsplatte B kann auch entfallen, wenn sichergestellt ist, daß die Feder über einen ausreichend großen Teil nicht unterätzt wird, sondern mit der unterliegenden isolierenden Schicht 3 mechanisch verbunden bleibt. Die Kondensatorplatten K können über Leitungen L mit einer Auswerteschaltung verbunden werden.

Das Bauteil kann mit dem beim ersten Beispiel beschriebenen Verfahren hergestellt werden, lediglich die Masken für die Strukturierung der dielektrischen Schicht 4 und für den isotropen Ätzprozeß (9) müssen angepaßt werden. Die Bezugsziffern für die einzelnen Schichten entsprechen denen in Fig. 1 - 3. Da das bewegliche Element nicht frei beweglich ist, ist die Sicherung gegen Herausfallen nicht vorgesehen und (im Bereich des Bauteils) kein Kontakt 6 vorhanden.

Die Photomaske 9 für den isotropen Ätzprozeß besitzt eine ausreichend große Öffnung, so daß wie bereits erläutert, mindestens das Masse-Element M und ein für die Federwirkung ausreichender Teil des Feder-Elementes F unterätzt werden (FIG 6). Ferner muß ein ausreichend großer Zwischenraum zwischen den Kondensatorplatten 2,7 freigeätzt werden. Die Befestigungsplatte B wird vorzugsweise nicht frei- oder unterätzt, um eine sichere mechanische Befestigung über die isolierende Schicht 3 mit dem Substrat 1 zu gewährleisten. In Fig 6 ist der freigeätzte Bereich 10 gestrichelt dargestellt und mit 10 bezeichnet. Die isolierenden Schichten sind nicht dargestellt.

Die Kondensatorplatten können auch im wesentlichen nebeneinanderliegend aus derselben leitenden Schicht oder Verdrahtungsebenen gebildet werden, und Masse-Element M und Feder-Element F können derart zwischen den Platten gebildet sein, daß die Masse im wesentlichen senkrecht zur Substratoberfläche beweglich ist.

Dieses Bauteil kann wie das erste Ausführungsbeispiel in ein Mikrosystem integriert werden. Bei einer Mehrlagenverdrahtung können die Kondensatorplatten aus den Verdrahtungsebenen gebildet werden. Die Leitungen L können aus einer höheren Verdrahtungsebene als die übrigen Strukturen hergestellt werden.

Wirkt auf das Masse-Element eine Kraft, so verbiegt sich die Feder F, und das Masse-Element verändert seinen Ort. Die Ortsveränderung kann als Kapazitätsänderung (Änderung von εᵣ) zwischen den Kondensatorplatten nachgewiesen werden. Durch die Rückstellkraft der Feder verändert sich das Kapazitätssignal monoton mit der einwirkenden Kraft. Das Bauelement kann daher als Beschleunigungssensor benutzt werden, indem man die Trägheitskraft auf das Masse-Element ausnutzt. Es ist jedoch genauso möglich, andere Krafteinwirkungen auf das Masse-Element zu detektieren. So können z.B. die Kraft einer strömenden Flüssigkeit oder eines Gases oder die direkte Krafteinwirkung eines externen mechanischen Bauteils nachgewiesen werden.

Weiterhin kann das Bauteil als Aktuator eingesetzt werden, indem man eine Spannung zwischen den Kondensatorplatten anlegt. Das elektrische Feld übt eine Kraft auf das Masse-Element aus und bewirkt eine Verschiebung. Insbesondere kann auch eine Wechsel-Spannung an die Kondensatorplatten angelegt werden, wodurch das dielektrische Masse-Element zu Schwingungen angeregt wird (Oszillator-Funktion). Da die mechanischen Schwingungsamplituden bei Anregung mit der Feder-Masse-System-Eigenfrequenz maximal werden, und zu einem Extremwert im Wechstromwiderstand führen, kann das Bauteil als frequenzbestimmendes Element in einer elkektronischen Schaltung verwendet werden (Resonator).

## Patentansprüche

1. Mikromechanisches Bauteil mit
- einer festen mikromechanischen Struktur, die ein aus einer oder mehreren leitenden Schichten gebildetes Kondensatorplattenpaar (K) umfaßt, und
- einer beweglichen mikromechanischen Struktur, die aus einer dielektrischen Schicht (4) gebildet ist
**dadurch gekennzeichnet**, daß die bewegliche mikromechanische Struktur in den Plattenzwischenraum einführbar oder aus ihm zumindest teilweise entfernbar ist.

2. Mikromechanisches Bauteil nach Anspruch 1, bei dem die bewegliche Struktur frei beweglich ist.

3. Mikromechanisches Bauteil nach Anspruch 1, bei dem die bewegliche Struktur federnd beweglich ist.

4. Mikromechanisches Bauteil nach einem der Ansprüche 1 -3, bei dem das Kondensatorplattenpaar aus zwei übereinanderliegenden leitenden Schichten (2,7) gebildet ist.

5. Mikromechanisches Bauteil nach einem der Ansprüche 1 -4, bei dem die bewegliche Struktur aus Siliziumnitrid besteht.

6. Mikromechanisches Bauteil nach einem der Ansprüche 2,4-5, bei dem Sicherungsmittel gegen Herausfallen der frei beweglichen mikromechanischen Struktur (4) vorgesehen sind, die mithilfe der leitenden Schicht (7) gebildet sind.

7. Herstellverfahren für ein mikromechanisches Bauteil nach einem der Ansprüche 1 - 6 mit folgenden Schritten:
- Bilden der festen und der beweglichen mikromechanischen Strukturen, die durch eine dazwischenliegende isolierende Schicht (3,5) voneinander getrennt sind,
- Entfernen der isolierenden Schicht um die bewegliche Struktur und mindestens teilweise im Plattenzwischenraum mit einem Ätzprozeß, der selektiv zu den festen und be weglichen Strukturen ist und eine isotrope Komponente aufweist.

8. Herstellverfahren nach Anspruch 7, bei dem die Kondensatorplatten aus zwei übereinanderliegenden leitenden Schichten (2,7) hergestellt werden, und dazwischen eine untere isolierende Schicht (3), die bewegliche dielektrische Struktur (4) und eine obere leitende Schicht (5) gebildet werden.

9. Mikrosystem auf einem Halbleitersubstrat (1) mit
- einem mikromechanischen Bauteil (BT) nach einem der Ansprüche 1 bis 5
und
- einer integrierten Schaltung (IS) mit Schaltungselementen,
**dadurch gekennzeichnet**, daß die Schaltungselemente mit Hilfe der leitenden Schicht oder mindestens einer der leitenden Schichten (7) verdrahtet sind.

10. Mikrosystem nach Anspruch 9, bei dem das Bauteil (BT) einen proportionalen oder einen nicht-proportionalen Kraftsensor einen Aktuator oder einen Oszillator/Resonator darstellt.

11. Mikrosystem nach einem der Ansprüche 9 bis 10, bei dem die integrierte Schaltung (IS) mehrere leitende Schich ten in Form einer Mehrlagenmetallisierung aufweist und die festen mikromechanischen Strukturen aus mehreren der Metallisierungsebene gebildet sind.

12. Mikrosystem nach einem der Ansprüche 9 bis 11, bei dem die integrierte Schaltung (IS) eine Ein- oder Mehrlagenmetallisierung mit der leitenden Schicht 7 aufweist und die festen mikromechanischen Strukturen aus derselben leitenden Schicht (7) gebildet sind.

13. Mikrosystem nach einem der Ansprüche 9 bis 12 , bei dem die bewegliche mikromechanische Struktur frei beweglich ist, und Sicherungsmittel gegen Herausfallen der frei beweglichen mikromechanischen Struktur vorgesehen sind, die mit Hilfe mindestens einer der Metallisierungsebenen gebildet sind.

14. Mikrosystem nach einem der Ansprüche 9 bis 13, bei dem die leitende Schicht (7) oder die leitenden Schichten (2, 7) aus einer Aluminiumlegierung oder im wesentlichen aus Wolfram bestehen und die isolierende Schicht (5) oder die isolierenden Schichten (3, 5, 8) aus einem Siliziumoxid besteht.

15. Herstellverfahren für ein Mikrosystem nach einem der Ansprüche 9 bis 14, bei dem
- die feste mikromechanische Struktur durch eine Struktu rierung der leitenden Schicht (7) erzeugt wird, die gleichzeitig mit der Strukturierung der leitenden Schicht (7) im Bereich der integrierten Schaltung er folgt,
mindestens ein Teil des Plattenzwischenraums und die be wegliche mikromechanische Struktur durch Entfernung der isolierenden Schicht (3,5) in einem Ätzprozeß freigelegt wird, der eine ausreichende Selektivität zur leitenden Schicht (7 )und zur dielektrischen Schicht (4) aufweist und eine isotrope Komponente besitzt.

16. Herstellverfahren nach Anspruch 15, bei dem als Ätzprozeß eine mikrowellenunterstützte isotrope Trockenätzung durchgeführt wird.

17. Herstellverfahren nach Anspruch 15, bei dem im Ätzprozeß eine gepufferte HF-LÖsung verwendet wird.

18. Herstellverfahren nach einem der Ansprüche 15 bis 17, bei dem die integrierte Schaltung (IS) und das mikromechanische Bauteil (BT) mit mehreren leitenden Schichten (2,7,) hergestellt werden, die mit weiteren isolierenden Schichten (3,5,8) abgedeckt werden, und bei dem der Ätzprozeß die isolierenden Schichten mit ausreichender Selektivität zu den leitenden Schichten ätzt.

## Claims

1. Micromechanical component having
- a fixed micromechanical structure which comprises a pair of capacitor plates (K) which are formed from one or more conductive layers, and
- a moveable micromechanical structure which is formed from a dielectric layer (4), characterized in that the moveable micromechanical structure can be introduced into the intermediate space between the plates or can be at least partially removed from said space.

2. Micromechanical component according to Claim 1, in which the moveable structure is freely moveable.

3. Micromechanical component according to Claim 1, in which the moveable structure is moveable in a sprung fashion.

4. Micromechanical component according to one of Claims 1-3, in which the pair of capacitor plates is formed from two conductive layers (2, 7) lying one on top of the other.

5. Micromechanical component as claimed in one of Claims 1-4, in which the moveable structure is composed of silicon nitride.

6. Micromechanical component as claimed in one of Claims 2, 4-5, in which means for ensuring that the freely moveable micromechanical structure (4) does not drop out are provided, said means being formed with the aid of the conductive layer (7).

7. Fabrication method for a micromechanical component according to one of Claims 1-6 having the following steps:
- the fixed and the moveable micromechanical structures which are separated from one another by an intermediate, insulating layer (3, 5) are formed,
- the insulating layer is removed around the moveable structure and at least partially from the intermediate space between the plates using an etching process which is selective with respect to the fixed and moveable structures and has an isotropic component.

8. Fabrication method according to Claim 7, in which the capacitor plates are fabricated from two conductive layers (2, 7) lying one on top of the other, and a lower insulating layer (3), the moveable dielectric structure (4) and an upper conductive layer (5) are formed between them.

9. Microsystem on a semiconductor substrate (1) having
- a micromechanical component (BT) according to one of Claims 1 to 5 and
- an integrated circuit (IS) with circuit elements, characterized in that the circuit elements are wired with the aid of the conductive layer or at least one of the conductive layers (7).

10. Microsystem according to Claim 9, in which the component (BT) constitutes a proportional or a non-proportional force sensor, an actuator or an oscillator/resonator.

11. Microsystem according to one of Claims 9 to 10, in which the integrated circuit (IS) has a plurality of conductive layers in the form of a multilayer metallization and the fixed micromechanical structures are formed from a plurality of the metallization levels.

12. Microsystem according to one of Claims 9 to 11, in which the integrated circuit (IS) has a single-layer or multilayer metallization with the conductive layer 7, and the fixed micromechanical structures are formed from the same conductive layer (7).

13. Microsystem according to one of Claims 9 to 12, in which the moveable micromechanical structure is freely moveable, and means for ensuring that the freely moveable micromechanical structure does not drop out are provided, said means being formed with the aid of at least one of the metallization levels.

14. Microsystem according to one of Claims 9 to 13, in which the conductive layer (7) or the conductive layers (2, 7) are composed of an aluminium alloy, or essentially from tungsten, and the insulating layer (5) or the insulating layers (3, 5) are composed of a silicon oxide.

15. Fabrication method for a microsystem according to one of Claims 9 to 14, in which
- the fixed micromechanical structure is produced by structuring the conductive layer (7), which is carried out simultaneously with the structuring of the conductive layer (7) in the vicinity of the integrated circuit,
at least part of the intermediate space between the plates and the moveable micromechanical structure being exposed by removing the insulating layer (3, 5) with an etching process which has a sufficient degree of selectivity with respect to the conductive layer (7) and the dielectric layer (4) and has an isotropic component.

16. Fabrication method according to Claim 15, in which a microwave-supported isotropic dry etching process is carried out as the etching process.

17. Fabrication method according to Claim 15, in which a buffered HF solution is used in the etching process.

18. Fabrication method according to one of Claims 15 to 17, in which the integrated circuit (IS) and the micromechanical component (BT) are fabricated with a plurality of conductive layers (2, 7) which are covered with further insulating layers (3, 5, 8), and in which the etching process etches the insulating layers with a sufficient degree of selectivity with respect to the conductive layers.

## Revendications

1. Composant micromécanique comportant
- une structure micromécanique fixe qui comprend un couple (K) de plaques de condensateur formé par une ou plusieurs couches conductrices, et
- une structure micromécanique mobile qui est formée par une couche (4) diélectrique,
caractérisé en ce que la structure micromécanique mobile peut être introduite dans l'intervalle entre les plaques ou en être au moins partiellement retirée.

2. Composant micromécanique suivant la revendication 1, dans lequel la structure mobile est librement mobile.

3. Composant micromécanique suivant la revendication 1, dans lequel la structure mobile est mobile de manière élastique.

4. Composant micromécanique suivant l'une des revendications 1 à 3, dans lequel le couple de plaques de condensateur est formé par deux couches (2, 7) conductrices superposées.

5. Composant micromécanique suivant l'une des revendications 1 à 4, dans lequel la structure mobile est en nitrure de silicium.

6. Composant micromécanique suivant l'une des revendications 2, 4 à 5, dans lequel il est prévu, pour empêcher la structure (4) micromécanique librement mobile de tomber, des moyens de blocage, qui sont formés à l'aide de la couche (7) conductrice.

7. Procédé de fabrication d'un composant micromécanique suivant l'une des revendications 1 à 6, comportant les étapes suivantes :
- on forme les structures micromécaniques fixe et mobile qui sont séparées l'une de l'autre par une couche (3, 5) isolante intermédiaire,
- on enlève la couche isolante autour de la structure mobile et au moins partiellement dans l'intervalle entre les plaques par une opération d'attaque chimique qui est sélective par rapport aux structures fixe et mobile et qui comporte un constituant isotrope.

8. Procédé de fabrication suivant la revendication 7, dans lequel on produit les plaques de condensateur par deux couches (2, 7) conductrices superposées et on forme entre les deux une couche (3) isolante, la couche (4) diélectrique mobile et une couche (5) supérieure conductrice.

9. Microsystème sur un substrat (1) semi-conducteur comportant
- un composant (BT) micromécanique suivant l'une des revendications 1 à 5,
et
- un circuit (IS) intégré comportant des éléments de circuit,
caractérisé en ce que les éléments de circuit sont câblés à l'aide de la couche conductrice ou d'au moins une des couches (7) conductrices.

10. Microsystème suivant la revendication 9, dans lequel le composant (BT) constitue un capteur de force proportionnel ou un capteur de force non proportionnel, un actuateur ou un oscillateur/résonateur.

11. Microsystème suivant l'une des revendications 9 à 10, dans lequel le circuit (IS) intégré comporte plusieurs couches conductrices sous la forme d'une métallisation multicouches et dans lequel les structures micromécaniques fixes sont formées par plusieurs des plans de métallisation.

12. Microsystème suivant l'une des revendications 9 à 11, dans lequel le circuit (IS) intégré comporte une métallisation monocouche ou multicouches par la couche (7) conductrice et dans lequel les structures micromécaniques sont formées par la même couche (7) conductrice.

13. Microsystème suivant l'une des revendications 9 à 12, dans lequel la structure micromécanique mobile est librement mobile et dans lequel il est prévu, pour empêcher la structure micromécanique librement mobile de tomber, des moyens de blocage, qui sont formés à l'aide d'au moins l'un des plans de métallisation.

14. Microsystème suivant l'une des revendications 9 à 13, dans lequel la couche (7) conductrice ou les couches (2, 7) conductrices sont en un alliage d'aluminium ou sensiblement en tungstène et dans lequel la couche (5) isolante ou les couches (3, 5, 8) isolantes sont en un oxyde de silicium.

15. Procédé de fabrication d'un microsystème suivant l'une des revendications 9 à 14, dans lequel
- on produit la structure micromécanique fixe par une structuration de la couche (7) conductrice qui s'effectue en même temps que la structuration de la couche (7) conductrice dans la région du circuit intégré,
on dégage par une opération d'attaque chimique au moins une partie de l'intervalle entre les plaques et la structure micromécanique mobile en enlevant la couche (3, 5) isolante, l'opération d'attaque chimique ayant une sélectivité suffisante par rapport à la couche (7) isolante et par rapport à la couche (4) diélectrique et comportant on constituant isotrope.

16. Procédé de fabrication suivant la revendication 15, dans lequel on effectue comme opération d'attaque chimique une attaque chimique isotrope en voie sèche assistée par hyperfréquence.

17. Procédé de fabrication suivant la revendication 15, dans lequel on utilise dans l'opération d'attaque chimique une solution de HF tamponnée.

18. Procédé de fabrication suivant l'une des revendications 15 à 17, dans lequel on produit le circuit (IS) intégré et le composant (BT) micromécanique par plusieurs couches (2, 7) conductrices qui sont recouvertes de couches (3, 5, 8) supplémentaires, et dans lequel l'opération d'attaque chimique attaque les couches isolantes avec une sélectivité suffisante par rapport aux couches conductrices.
